(19)

Europäisches
Patentamt
European
Patent Office
Office européen
des brevets

(11)     **EP 4 510 172 A1**

(12)                    **EUROPEAN PATENT APPLICATION**
                     published in accordance with Art. 153(4) EPC

(43) Date of publication:
**19.02.2025 Bulletin 2025/08**

(21) Application number: **23788217.0**

(22) Date of filing: **04.04.2023**

(51) International Patent Classification (IPC):
*H01L 21/3205* (2006.01)     *H01L 21/768* (2006.01)
*H01L 23/522* (2006.01)     *H01L 23/532* (2006.01)

(52) Cooperative Patent Classification (CPC):
**H01L 21/3205; H01L 21/768; H01L 23/522;**
**H01L 23/532**

(86) International application number:
**PCT/JP2023/013964**

(87) International publication number:
**WO 2023/199798 (19.10.2023 Gazette 2023/42)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **12.04.2022 JP 2022065937**

(71) Applicant: **Sony Semiconductor Solutions**
**Corporation**
**Atsugi-shi, Kanagawa 243-0014 (JP)**

(72) Inventor: **TOZAWA, Katsunori**
**Atsugi-shi, Kanagawa 243-0014 (JP)**

(74) Representative: **MFG Patentanwälte**
**Meyer-Wildhagen Meggle-Freund**
**Gerhard PartG mbB**
**Amalienstraße 62**
**80799 München (DE)**

(54)     **SEMICONDUCTOR DEVICE, METHOD FOR PRODUCING SEMICONDUCTOR DEVICE, AND**
          **ELECTRONIC APPARATUS**

(57)     Provided are a semiconductor device, a method for manufacturing the semiconductor device, and an electronic apparatus having the semiconductor device capable of preventing film peeling of an interlayer film laminated on a wiring pattern.

The semiconductor device according to the present disclosure has a configuration having a silicon substrate, an insulating film laminated on the silicon substrate, at least one or more wiring patterns formed on the insulating film, an interlayer film laminated between the one or more wiring patterns, and a conductive protective film embedded in an interlayer film opening formed in the interlayer film. Furthermore, the method for manufacturing a semiconductor device has a configuration having a step of forming at least one or more wiring patterns on an upper surface of an insulating film, a step of forming an interlayer film on an upper surface of the wiring pattern, a step of forming an interlayer film opening having a predetermined shape in the interlayer film, and a step of forming a conductive protective film on an upper surface of the interlayer film and embedding the conductive protective film in the interlayer film opening.

*FIG. 15*

**Description**

TECHNICAL FIELD

The present disclosure relates to a semiconductor device having a film peeling prevention structure for an interlayer insulating film formed on a wiring pattern of the semiconductor device, a method for manufacturing the semiconductor device, and an electronic apparatus having the semiconductor device.

BACKGROUND ART

Conventionally, with a progress of miniaturization of a semiconductor process and an increase in speed of a semiconductor element, high integration of the semiconductor element has progressed. In response to the progress of the high integration of the semiconductor element, various semiconductor structures and packages have appeared. Furthermore, power consumption of the semiconductor element also increases with the high integration, and measures against a temperature rise and its adverse effects associated with this increase are problems.

For example, in the semiconductor element, a redistribution layer (RDL) in which a layer of a logic circuit and the like including a wiring pattern of copper (Cu) and an interlayer insulating film that insulates the wiring pattern configuring the logic circuit and the like are alternately laminated in multiple layers is formed.

For the interlayer insulating film forming the redistribution layer, for example, an insulating material such as a silicon oxide film (silicon dioxide: $SiO_2$) or a silicon nitride film (silicon nitride: $Si_3N_4$), a low dielectric constant dielectric material (low-k material) for suppressing parasitic capacitance generated in the wiring, or the like is used.

However, since the silicon oxide film and the low dielectric constant dielectric material have a small linear expansion coefficient (for example, in the case of the silicon oxide film, it is 0.51 to 0.58 × $10^{-6}$/K), the silicon oxide film and the low dielectric constant dielectric material do not greatly expand and contract even when there is a temperature change accompanying heat generation of the semiconductor element. On the other hand, copper (Cu) forming the wiring pattern has a linear expansion coefficient larger than those of these materials (16.5 × $10^{-6}$/K at 20°C), and thus expands and contracts due to the temperature change of the semiconductor element.

Therefore, even when the copper (Cu) wiring pattern expands and contracts due to the temperature change, the interlayer insulating film laminated on the copper (Cu) wiring pattern does not greatly expand and contract in conjunction therewith. As a result, there arises a problem that the interlayer insulating film is peeled off due to a difference in the linear expansion coefficient between the two. For this reason, it is necessary to prevent film peeling of the interlayer insulating film due to the difference in the linear expansion coefficient and the temperature rise or the temperature change.

Patent Document 1 discloses a semiconductor device in which, in a semiconductor chip in which an interlayer insulating film with a wiring and a stopper material alternately sandwiched is laminated on a substrate and a surface protective film is laminated on an upper surface thereof, a stress generated in the surface protective film is reduced to prevent film peeling of the interlayer insulating film.

Specifically, the semiconductor device includes an element formed in a chip region of the substrate, a plurality of interlayer insulating films formed on the substrate, a wiring formed on at least one of the plurality of interlayer insulating films, and a plug formed on at least one of the plurality of interlayer insulating films and coupling the element and the wiring or coupling the wirings to each other.

Moreover, in the semiconductor device, the surface protective film is formed on the plurality of interlayer insulating films.

Furthermore, the surface protective film in the chip region includes a plurality of portions divided from each other. By dividing the surface protective film that generates the stress in this manner, the generated stress is dispersed to a small extent to prevent film peeling of the interlayer insulating film.

CITATION LIST

PATENT DOCUMENT

Patent Document 1: Japanese Patent Application Laid-Open No. 2006-318989

SUMMARY OF THE INVENTION

PROBLEMS TO BE SOLVED BY THE INVENTION

As described above, the semiconductor device described in Patent Document 1 disperses the stress generated by the temperature change to be small by dividing the surface protective film. However, merely by dividing the surface protective film formed on an uppermost surface of the semiconductor device, the effect of alleviating the stress generated in an interlayer insulating film layer disposed in a far lower layer is not sufficient, and the effect of preventing film peeling is considered to be limited.

Furthermore, the stopper material formed in an opening region where the surface protective film is not formed is exposed. For this reason, in a case where the stopper material includes, for example, a metal material such as aluminum (Al), there is a problem that corrosion occurs and reliability is deteriorated.

The present disclosure has been made in view of such problems, and an object of the present disclosure is to provide a semiconductor device, a method for manufacturing a semiconductor device, and an electronic apparatus capable of preventing film peeling between a wiring pattern and an interlayer film by providing an interlayer film opening in an interlayer insulating film (hereinafter, referred to as an "interlayer film") laminated on a wiring pattern and embedding a conductive protective film in the interlayer film opening.

SOLUTIONS TO PROBLEMS

The present disclosure has been made to solve the above-described problems, and a first aspect thereof is a semiconductor device having a silicon substrate, an insulating film laminated on the silicon substrate, at least one or more wiring patterns formed on the insulating film, an interlayer film laminated between the one or more wiring patterns, and a conductive protective film embedded in an interlayer film opening formed in the interlayer film.

Furthermore, in the first aspect, an entire surface of the conductive protective film may be covered with a surface protective film.

Furthermore, in the first aspect, the surface protective film that covers the conductive protective film may have an opening.

Furthermore, in the first aspect, the conductive protective film may be formed to be wider than a width of the wiring pattern, and a peripheral edge of the interlayer film opening is covered with the conductive protective film via the interlayer film.

Furthermore, in the first aspect, the interlayer film opening may be opened wider than a width of the wiring pattern, and an upper surface and a peripheral side surface of the wiring pattern are covered with the conductive protective film.

Furthermore, in the first aspect, at least two or more of the wiring patterns formed on a same plane on the insulating film or the interlayer film may be electrically coupled to each other via a connecting conductive protective film that connects the conductive protective films embedded in the interlayer film openings of the interlayer film on the respective wiring patterns.

Furthermore, in the first aspect, the surface protective film may include an inorganic film including silicon dioxide ($SiO_2$) and silicon nitride ($Si_3N_4$), an organic film such as a polyimide-based resin, or a laminated structure of these films.

Furthermore, in the first aspect, a linear expansion coefficient of the conductive protective film may have a relationship that is larger than a linear expansion coefficient of the insulating film and smaller than a linear expansion coefficient of a material of the wiring pattern.

Furthermore, in the first aspect, the conductive protective film may be titanium (Ti), nickel (Ni), or an alloy including these elements.

Furthermore, in the first aspect, the conductive protective film may have a laminated structure including at least one or more layers of the titanium (Ti), nickel (Ni), or alloy including these elements.

A second aspect of the present disclosure is a method for manufacturing a semiconductor device, the method having a step of forming a silicon substrate, a step of forming an insulating film on an upper surface of the silicon substrate, a step of forming at least one or more wiring patterns on an upper surface of the insulating film, a step of forming an interlayer film on an upper surface of the wiring pattern, a step of forming an interlayer film opening having a predetermined shape in the interlayer film, and a step of forming a conductive protective film on an upper surface of the interlayer film and embedding the conductive protective film in the interlayer film opening.

Furthermore, in the second aspect, the step of forming the silicon substrate may have a step of bonding a circuit substrate having a wiring pattern on a lower surface, and a step of providing a through-Si electrode coupled to the wiring pattern from the upper surface of the silicon substrate.

A third aspect of the present disclosure is an electronic apparatus having a semiconductor device having a silicon substrate, an insulating film laminated on the silicon substrate, at least one or more wiring patterns formed on the insulating film, an interlayer film laminated between the one or more wiring patterns, and a conductive protective film embedded in an interlayer film opening formed in the interlayer film.

By adopting the aspects described above, it is possible to provide a semiconductor device, a method for manufacturing the semiconductor device, and an electronic apparatus having the semiconductor device capable of preventing film peeling of an interlayer film laminated on a wiring pattern.

BRIEF DESCRIPTION OF DRAWINGS

Fig. 1 is a plan view, an X-X line cut end view, and a Y-Y line cut end view of a first embodiment of a semiconductor device according to the present disclosure.

Fig. 2 is an explanatory view of film peeling in a case where an interlayer film opening is not provided in an interlayer film.

Fig. 3 is a comparative explanatory view of film peeling in a case where the interlayer film opening is provided in the interlayer film.

Fig. 4 is an explanatory view of a manufacturing step of the first embodiment of the semiconductor device according to the present disclosure (part 1).

Fig. 5 is an explanatory view of the manufacturing step of the first embodiment of the semiconductor device according to the present disclosure (part 2).

Fig. 6 is an explanatory view of the manufacturing step of the first embodiment of the semiconductor device according to the present disclosure (part 3).

Fig. 7 is an explanatory view of the manufacturing step of the first embodiment of the semiconductor device according to the present disclosure (part 4).

Fig. 8 is an explanatory view of the manufacturing step of the first embodiment of the semiconductor device according to the present disclosure (part 5).

Fig. 9 is an explanatory view of the manufacturing step of the first embodiment of the semiconductor device according to the present disclosure (part 6).

Fig. 10 is an explanatory view of the manufacturing step of the first embodiment of the semiconductor device according to the present disclosure (part 7).

Fig. 11 is an explanatory view of the manufacturing step of the first embodiment of the semiconductor device according to the present disclosure (part 8).

Fig. 12 is an explanatory view of the manufacturing step of the first embodiment of the semiconductor device according to the present disclosure (part 9).

Fig. 13 is an explanatory view of the manufacturing step of the first embodiment of the semiconductor device according to the present disclosure (part 10).

Fig. 14 is an explanatory view of the manufacturing step of the first embodiment of the semiconductor device according to the present disclosure (part 11).

Fig. 15 is an explanatory view of the manufacturing step of the first embodiment of the semiconductor device according to the present disclosure (part 12).

Fig. 16 is a plan view and an X-X line cut end view of a second embodiment of a semiconductor device according to the present disclosure.

Fig. 17 is a plan view and an X-X line cut end view of a third embodiment of the semiconductor device according to the present disclosure.

Fig. 18 is a plan view and a Y-Y line cut end view of a fourth embodiment of the semiconductor device according to the present disclosure.

Fig. 19 is a plan view and a Y-Y line cut end view of a fifth embodiment of the semiconductor device according to the present disclosure.

Fig. 20 is a plan view of a sixth embodiment of the semiconductor device according to the present disclosure.

Fig. 21 is a block view of an electronic apparatus having the semiconductor device according to the present disclosure.

MODE FOR CARRYING OUT THE INVENTION

Next, a form for carrying out the present disclosure (hereinafter, referred to as an "embodiment") will be described in the following order with reference to the drawings. In the following drawings, the same or similar parts are denoted by the same or similar reference numerals. However, the drawings are schematic, and a dimensional ratio and the like of each part do not necessarily match actual ones. Furthermore, it is needless to say that the drawings include parts having different dimensional relationships and ratios.

1. First Embodiment of Semiconductor Device According to Present Disclosure

2. Manufacturing Step of First Embodiment of Semiconductor Device According to Present Disclosure

3. Second Embodiment of Semiconductor Device According to Present Disclosure

4. Third Embodiment of Semiconductor Device According to Present Disclosure

5. Fourth Embodiment of Semiconductor Device According to Present Disclosure

6. Fifth Embodiment of Semiconductor Device According to Present Disclosure

7. Sixth Embodiment of Semiconductor Device According to Present Disclosure

8. Electronic Apparatus Having Semiconductor Device According to Present Disclosure

<1. First Embodiment of Semiconductor Device According to Present Disclosure>

[Basic Configuration of First Embodiment]

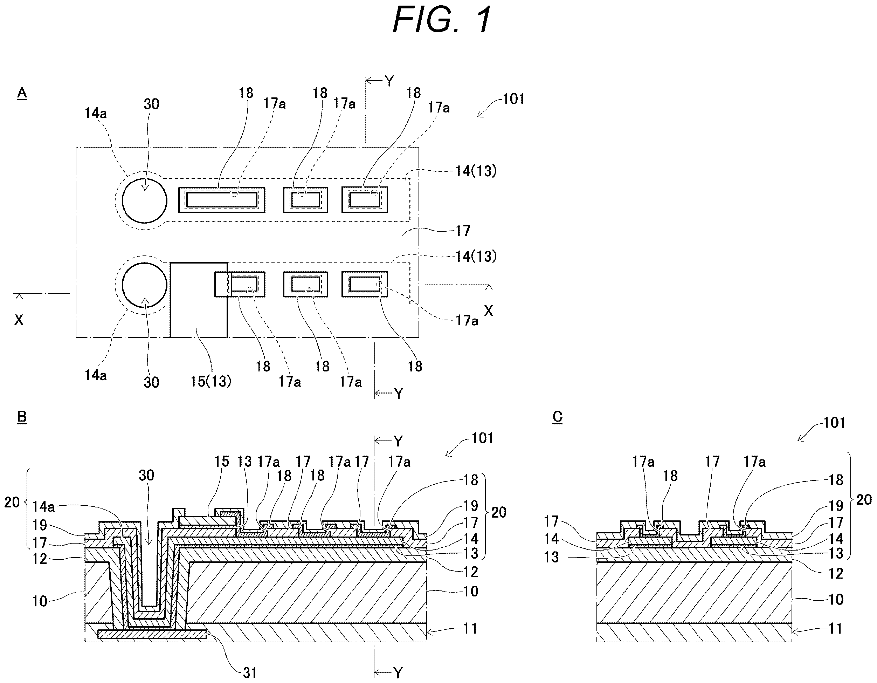

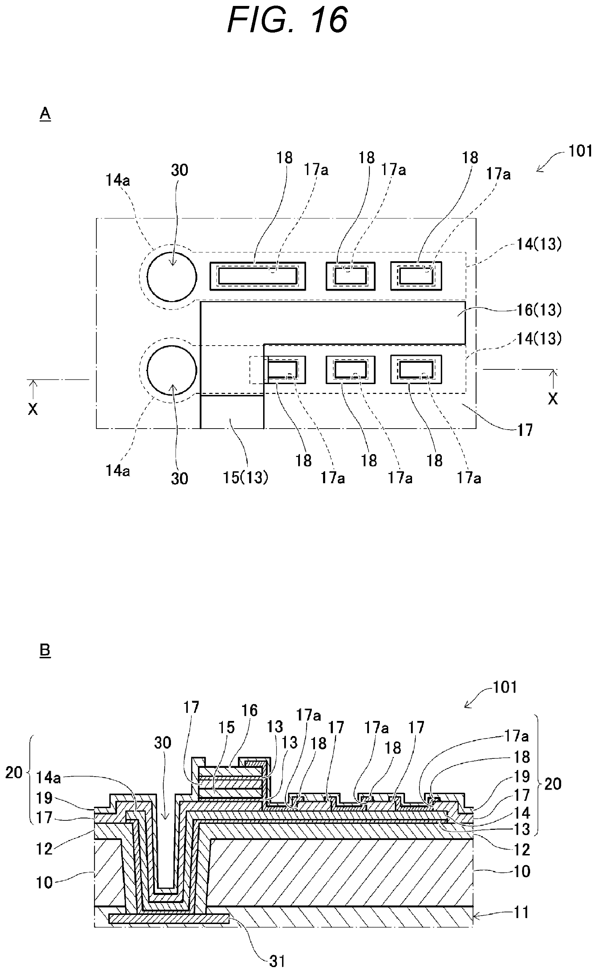

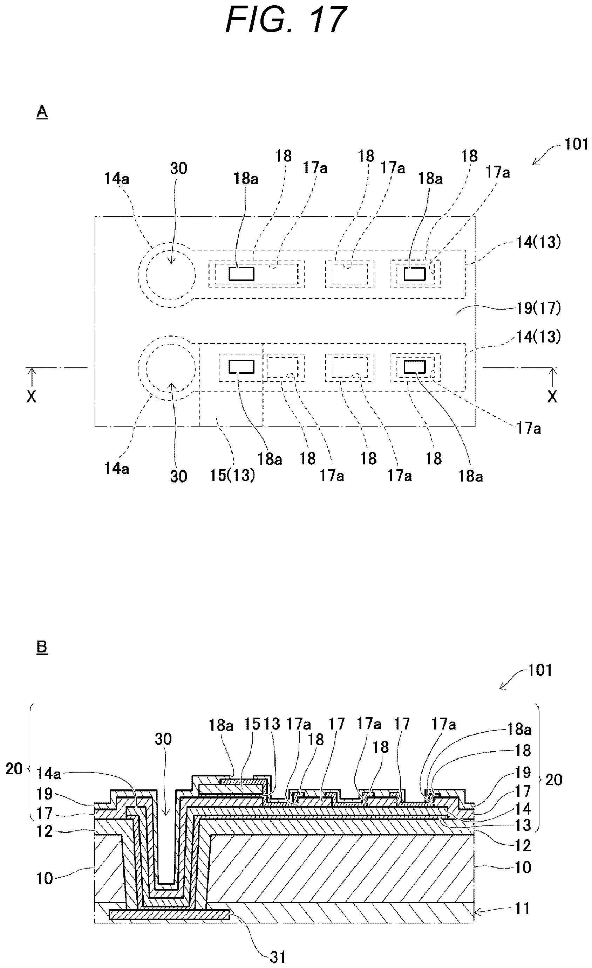

Fig. 1A is a plan view of a first embodiment of a semiconductor device 101 according to the present disclosure, Fig. 1B is an X-X line cut end view of the semiconductor device, and Fig. 1C is a Y-Y line cut end view of the semiconductor device (hereinafter, sometimes referred to as a "plan view", an "X end view", and a "Y end view", respectively). Note that Fig. 1A is a plan view before a surface protective film 19 described later is formed. The same applies to Figs. 16A, 18A, 19A, and 20A except for Fig. 17A.

Furthermore, a direction parallel to a cutting line of an X-X line cut end surface may be referred to as an "X direction", and a direction parallel to a cutting line of a Y-Y line cut end surface may be referred to as a "Y direction".

Hereinafter, a basic configuration of the first embodiment of the semiconductor device 101 according to the present disclosure will be described with reference to the drawings. Note that the following description will be made with reference to the drawings illustrating the semiconductor device 101 in a wafer state before singulation. The same applies to a second embodiment to a sixth embodiment.

In the first embodiment of the semiconductor device 101 according to the present disclosure, as illustrated in the X end view of Fig. 1B, a first wiring pattern 14 is formed on an insulating film 12 laminated on an upper surface of a silicon substrate 10, an upper surface thereof is covered with an interlayer film 17, interlayer film openings 17a are provided in the interlayer film 17 at predetermined intervals, and a conductive protective film 18 is embedded in the interlayer film openings 17a. That is, the interlayer film openings 17a are provided at predetermined intervals in the interlayer film 17, and the conductive protective film 18 is embedded in the interlayer film openings 17a to alleviate a stress caused by a difference in a linear expansion coefficient between the first wiring pattern 14 and the interlayer film 17, therefore, a film peeling 50 of the interlayer film 17 is prevented.

Hereinafter, a configuration example of the first embodiment of the semiconductor device 101 will be described in more detail. The semiconductor device 101 is formed using, for example, a silicon substrate 10 including silicon (silicon: Si) as a base material. The insulating film 12 is laminated on the upper surface of the silicon substrate 10. The insulating film 12 includes, for example, silicon dioxide ($SiO_2$), and electrically insulates the silicon substrate 10 from a redistribution layer 20 formed on the silicon substrate 10.

As illustrated in Fig. 1B, the redistribution layer 20 is formed on the insulating film 12. The redistribution layer 20 is a wiring layer formed by alternately laminating a wiring pattern and the interlayer film 17 which is an insulating film by forming a first wiring pattern 14 on the insulating film 12, laminating the interlayer film 17 on an upper surface thereof, and further forming a second wiring pattern on an upper surface thereof.

Specifically, the redistribution layer 20 is formed by forming a seed metal 13 on the insulating film 12, forming the first wiring pattern 14 thereon, laminating the interlayer film 17 thereon, further forming a second wiring pattern 15 in a partial region on the interlayer film 17, and covering an upper surface thereof with the surface protective film 19.

Furthermore, the interlayer film opening 17a having a predetermined shape is provided in the interlayer film 17 laminated between the first wiring pattern 14 and the second wiring pattern 15. Then, the conductive protective film 18 having conductivity is embedded in the interlayer film opening 17a.

The first wiring pattern 14 and the second wiring pattern 15 are electric signal wirings including, for example, copper (Cu). Note that the second wiring pattern 15 may be covered with the interlayer film 17 to provide the interlayer film opening 17a having a predetermined shape, and the conductive protective film 18 may be embedded.

As described above, the first wiring pattern 14 is formed on the seed metal 13 formed on the upper surface of the insulating film 12. Similarly, the second wiring pattern 15 is formed on the seed metal 13 formed on the upper surface of the interlayer film 17 laminated between the second wiring pattern 15 and the first wiring pattern 14.

The seed metal 13 is a thin film of copper (Cu) formed on the insulating film 12. The seed metal 13 serves as a seed layer for growing plated copper (Cu) when the first wiring pattern 14 is formed by electrolytic plating.

The interlayer film 17 includes, for example, an insulating material such as a silicon oxide film (silicon dioxide: $SiO_2$) or a silicon nitride film (silicon nitride: $Si_3N_4$), or a low dielectric constant dielectric material (low-k material). Note that as described above, the insulating material and the low dielectric constant dielectric material used for the interlayer film 17 have a linear expansion coefficient smaller than that of copper (Cu) forming the wiring pattern.

As illustrated in Figs. 1A to 1C, the upper surface of the interlayer film 17 in contact with a peripheral end surface of the interlayer film opening 17a is covered with the conductive protective film 18. Furthermore, the conductive protective film 18 in contact with the second wiring pattern 15 covers a side end and an upper surface of the side end of the second wiring pattern 15. Therefore, the second wiring pattern 15 is electrically coupled to the first wiring pattern 14 via the conductive protective film 18.

The conductive protective film 18 is a protective film having conductivity. A material having a linear expansion coefficient of the conductive protective film 18 larger than that of the interlayer film 17 and smaller than that of copper (Cu) forming the wiring pattern such as the first wiring pattern 14 and the second wiring pattern 15 is selected.

Specifically, the conductive protective film 18 includes, for example, titanium (Ti), nickel (Ni), or an alloy including these elements. Furthermore, the conductive protective film 18 may have a laminated structure including at least one or more layers of titanium (Ti), nickel (Ni), or an alloy including these elements.

A linear expansion coefficient of titanium (Ti) is $8.6 \times 10^{-6}$/K (at 20°C), and a linear expansion coefficient of nickel (Ni) is $13.4 \times 10^{-6}$/K (at 20°C), both of which are smaller than the linear expansion coefficient of copper (Cu) ($16.5 \times 10^{-6}$/K at 20°C) and larger than that of the silicon oxide film.

As illustrated in Figs. 1B and 1C, the upper surface of the conductive protective film 18 is covered with the surface protective film 19 except for the upper surface of the second wiring pattern 15.

The surface protective film 19 is a film that prevents a filler included in a molding resin from coming into contact when the semiconductor device 101 is molded with the molding resin in a state of a semiconductor chip and protects the semiconductor device from an influence of an external stress and an external atmosphere.

Specifically, the surface protective film 19 includes, for example, an inorganic film such as silicon dioxide ($SiO_2$) or silicon nitride ($Si_3N_4$), an organic film such as a polyimide-based resin, or a laminated structure of these films.

Furthermore, a through-Si electrode (TSV: through-silicon via, hereinafter referred to as "TSV") 30 is provided to penetrate a left side of Fig. 1A or 1B. The TSV 30 is an electrode that vertically penetrates an inside of the silicon substrate 10 and couples the wiring patterns on the upper surface and the lower surface of the silicon substrate 10 or in the middle thereof.

Specifically, the TSV 30 has a through-hole formed from the upper surface to the lower surface of the silicon substrate 10, and a conductive metal film such as copper (Cu) is formed on an inner peripheral surface of the through-hole. Therefore, the redistribution layer 20 formed on the upper surface of the silicon substrate 10 and a lower surface wiring pattern 31 formed on the lower surface of the silicon substrate 10 are electrically coupled.

As illustrated in Fig. 1B, the inside of the TSV 30 is connected to the insulating film 12 laminated on the upper surface of the silicon substrate 10 by covering the peripheral side surface in the through-hole with the insulating film 12 to a predetermined thickness. The upper surface of the insulating film 12 covering the peripheral side surface in the TSV 30 is formed with the seed metal 13 and connected to the seed metal 13 formed on the upper surface of the insulating film 12 laminated on the upper surface of the silicon substrate 10.

Similarly, a conductive metal film such as copper (Cu) is formed on the upper surface of the seed metal 13 on the peripheral side surface in the TSV 30, and is connected to the first wiring pattern 14. That is, the first wiring pattern 14 extends on the inner peripheral surface of the TSV 30. Moreover, an upper surface of the first wiring pattern 14 is covered with the interlayer film 17, and an uppermost surface is covered with the surface protective film 19.

Furthermore, a bottom surface of the first wiring pattern 14 extending in the TSV 30 is in contact with the lower surface wiring pattern 31 formed on the circuit substrate 11 on the lower surface of the silicon substrate 10 via the seed metal 13. Therefore, the first wiring pattern 14 and the lower surface wiring pattern 31 are electrically coupled.

That is, by providing the TSV 30, the first wiring pattern 14 of the redistribution layer 20 formed on the upper surface of the silicon substrate 10 and the lower surface wiring pattern 31 formed in the circuit substrate 11 on the lower surface of the silicon substrate 10 can be electrically coupled.

Here, the circuit substrate 11 is a logic substrate including a circuit element and the like including an active element such as a transistor, a memory substrate, a substrate of a sensor substrate or a solid-state imaging element, or a substrate such as a sensor edge processor. Note that the sensor edge processor is, for example, a processor that preprocesses a huge amount of high-definition pixel data from the solid-state imaging element and the like.

As illustrated in Fig. 1A, the TSV 30 is formed in a substantially circular shape in plan view. This drawing illustrates an example in which two TSVs 30 are provided. Land patterns 14a and 14a having a substantially circular shape are formed on peripheral edges of the TSVs 30 and 30, respectively. As illustrated in this drawing, first wiring patterns 14 and 14 extend from the land patterns 14a and 14a in parallel in a right direction.

The entire upper surface of the first wiring pattern 14 including the land pattern 14a and the entire upper surface of the insulating film 12 are covered with the interlayer film 17. Moreover, as illustrated in Fig. 1B, the seed metal 13 is formed on the upper surface of the interlayer film 17 near one land pattern 14a (land pattern 14a on a lower side in Fig. 1A), and substantially rectangular second wiring pattern 15 is formed on the upper surface thereof.

As described above, the interlayer film openings 17a having a predetermined shape are provided at predetermined intervals in the interlayer film 17 covering the upper surface of the first wiring pattern 14, and the conductive protective film 18 having a linear expansion coefficient larger than that of the interlayer film 17 and smaller than that of the first wiring pattern 14 is embedded in the regions of the interlayer film openings 17a. Therefore, a stress generated by a difference in the linear expansion coefficient between the first wiring pattern 14 and the interlayer film 17 can be alleviated.

Note that the shape of the interlayer film opening 17a in plan view is represented in a substantially rectangular shape in Fig. 1A, but is not limited to the substantially rectangular shape, and substantially rectangular corner portions may be chamfered or formed in a curved surface. Furthermore, the shape may be a circular shape, a substantially oval shape, or a substantially elliptical shape. With such a formation, it is possible to prevent stress concentration on the corner portions of the interlayer film opening 17a. Therefore, it is possible to prevent occurrence of cracks and the like in the interlayer film opening 17a.

[Principle of Stress Alleviation]

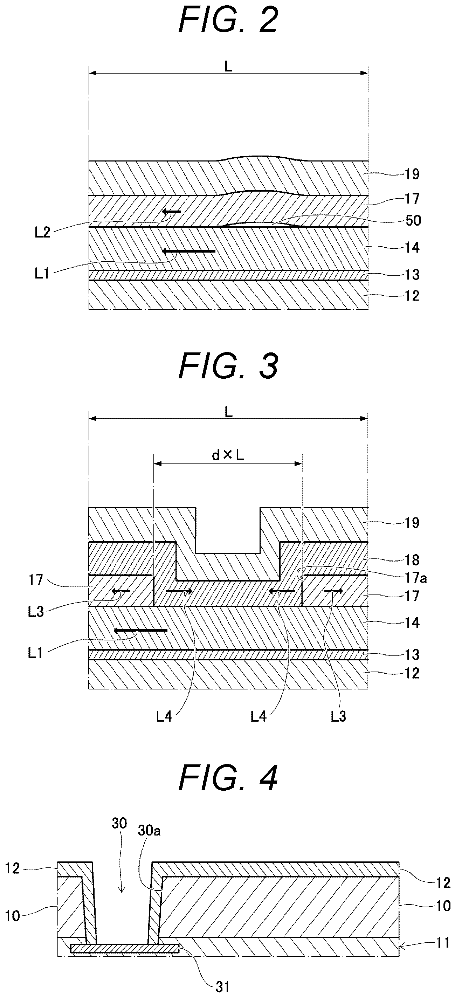

Next, a cause of the stress generated between the first wiring pattern 14 and the interlayer film 17, which causes the film peeling 50, and a measure for alleviating the stress will be described with reference to Figs. 2 and 3. Fig. 2 is an explanatory view of the film peeling 50 in a case where the interlayer film opening 17a is not provided in the interlayer film 17. Furthermore, Fig. 3 is a comparative explanatory view of the film peeling 50 in a case where the interlayer film opening 17a is provided in the interlayer film 17 and the conductive protective film 18 is embedded in the interlayer film opening 17a.

First, a case where the interlayer film opening 17a is not provided in the interlayer film 17 will be described with reference to Fig. 2. In the manufacturing step of the semiconductor device 101, the first wiring pattern 14 is formed on the upper surface of the insulating film 12 via the seed metal 13 in the wafer state. Next, the interlayer film 17 is laminated on the entire upper surface of the first wiring pattern 14. Next, the surface protective film 19 is formed on the entire upper surface of the interlayer film 17. Such a manufacturing step is performed at a high temperature. When the forming step of the surface protective film 19 is completed, the semiconductor chip of the semiconductor device 101 is returned to a room temperature.

Here, attention is paid to the first wiring pattern 14 and the interlayer film 17. The linear expansion coefficient of the first wiring pattern 14 and the linear expansion coefficient of the interlayer film 17 are different from each other as described above. Therefore, when returning to a room temperature, as illustrated in Fig. 2, the first wiring pattern 14 tends to contract by a length L1 in a section of the length L. On the other hand, the interlayer film 17 tends to contract by a length L2.

In this case, it is assumed that a length of the first wiring pattern 14 and the interlayer film 17 in Fig. 2 is L, and a temperature change is $\Delta T$. Furthermore, it is assumed that the linear expansion coefficient of the first wiring pattern 14 is $\alpha$, and the linear expansion coefficient of the interlayer film 17 is $\beta$. In this case, from the above description, a relationship between both linear expansion coefficients is $\alpha > \beta$.

Therefore, the length L1 of the first wiring pattern 14 to be contracted is

$$L1 = \alpha \times L \times \Delta T.$$

On the other hand, the length L2 of the interlayer film 17 to be contracted is

$L2 = \beta \times L \times \Delta T$. Then, the length L1 of the first wiring pattern 14 to be contracted is longer than the length L2 of the interlayer film 17 to be contracted. That is, L1 > L2.

Furthermore, a length La of a difference between the length L1 and the length L2, by which both portions are to be contracted is

$$La = L1 - L2 = (\alpha - \beta) \times L \times \Delta T.$$

Therefore, a difference in the length La is generated between the stress to be contracted by the length L1 and the stress to be contracted by the length L2. For this reason, the stress due to the length La of the difference acts, and the film peeling 50 occurs between the first wiring pattern 14 and the interlayer film 17 laminated on the upper surface thereof.

The above is the reason why the film peeling 50 occurs.

Next, a case where the interlayer film opening 17a is provided in the interlayer film 17 and the conductive protective film 18 is embedded will be described with reference to Fig. 3. In the manufacturing step of the semiconductor device 101, the interlayer film 17 is laminated on the upper surface of the first wiring pattern 14, and the interlayer film opening 17a having a predetermined shape is provided in the interlayer film 17. Next, the conductive protective film 18 is formed in such a manner as to embed the interlayer film opening 17a in the upper surface of the interlayer film 17. Next, the surface protective film 19 is formed on the entire upper surface of the conductive protective film 18, and then the temperature is returned to a room temperature.

In this case, when returning to a room temperature, as illustrated in Fig. 3, in the section of the length L, the first wiring pattern 14 tends to contract by the length L1, and the interlayer film 17 tends to contract by lengths L3 and L3 on the left and right sides, respectively. At this time, the directions in which the left and right interlayer films 17 and 17 sandwiching the interlayer film opening 17a are to be contracted are opposite to each other. However, there is no change in contraction of the interlayer film 17 itself.

That is, the interlayer film 17 tends to be contracted by L3 + L3 = (2 × L3).

Similarly, the conductive protective film 18 tends to be contracted. The left and right lengths by which the conductive protective film 18 is to be contracted are lengths L4 as illustrated in Fig. 3. Therefore, the entire conductive protective film 18 tends to be contracted by L4 + L4 = (2 × L4).

Here, the length (2 × L4) by which the conductive protective film 18 is to be contracted can be represented as, (2 × L4) = $\gamma$ × d × L × $\Delta$T. Where $\gamma$ is a linear expansion coefficient of the conductive protective film 18, d is a ratio between the length of the conductive protective film 18 and the length L of the section, and d < 1.

Similarly, the length (2 × L3) by which the interlayer film 17 is to be contracted can be represented as, (2 × L3) = $\beta$ × (1 - d) × L × $\Delta$T. Where (1 - d) is a ratio between the length of the interlayer film 17 and the length L of the section, and (1 - d) < 1.

Then, a length Lb of a difference between the length L1 by which the first wiring pattern 14 is to be contracted and a length {(2 × L3) + (2 × L4)} by which the interlayer film 17 and the conductive protective film 18 are to be contracted is,

$$Lb = L1 - (2 \times L3 + 2 \times L4) = (\alpha \times L \times \Delta T) - [\{\beta \times (1 - d) \times L \times \Delta T\} + (\gamma \times d \times L \times \Delta T)] = \{(\alpha - \beta) - (\gamma - \beta) \times d\} \times L \times \Delta T.$$

Here, when a difference between the length Lb in Fig. 3 and the length La in Fig. 2 is expressed, it is,

$$Lb - La = [\{(\alpha - \beta) - (\gamma - \beta) \times d\} \times L \times \Delta T] - [(\alpha - \beta) \times L \times \Delta T] = -(\gamma - \beta) \times d \times L \times \Delta T < 0 \ (\because \gamma > \beta). \text{ That is, } Lb < La.$$

Therefore, from the above calculation result, the length Lb to be contracted in the case of Fig. 3 is smaller than the length La to be contracted in the case of Fig. 2. That is, in the case of Fig. 3, the difference in the length to be contracted between the first wiring pattern 14 and the interlayer film 17 is smaller.

As described above, the interlayer film opening 17a is provided in the upper surface of the interlayer film 17, and the conductive protective film 18 is formed in such a manner as to embed the interlayer film opening 17a, whereby the length Lb by which the first wiring pattern 14 and the interlayer film 17 tend to be contracted is reduced. As a result, the stress acting between the first wiring pattern 14 and the interlayer film 17 is reduced.

Therefore, with the configuration as illustrated in Fig. 3, the stress acting between the first wiring pattern 14 and the interlayer film 17 can be reduced, and the film peeling 50 between the first wiring pattern 14 and the interlayer film 17 can be prevented. The above is the reason why the film peeling 50 can be prevented.

As described above, in the first embodiment of the semiconductor device 101 according to the present disclosure, the interlayer film openings 17a are provided at predetermined intervals in the interlayer film 17 laminated on the first wiring pattern 14, and the conductive protective film 18 is embedded. Therefore, the stress caused by the difference in the linear expansion coefficient between the first wiring pattern 14 and the interlayer film 17 can be alleviated, and thus the film peeling 50 of the interlayer film 17 can be prevented.

Furthermore, by appropriately selecting the linear expansion coefficient $\gamma$ of the conductive protective film 18, a value of a ratio d of the length of the interlayer film opening 17a to the section L, a shape of the interlayer film opening 17a, and the like, the effect of preventing the film peeling 50 can be further enhanced.

Furthermore, by providing a relationship of $\alpha > \gamma > \beta$ among the linear expansion coefficient $\alpha$ of the first wiring pattern 14, the linear expansion coefficient $\gamma$ of the conductive protective film 18, and the linear expansion coefficient $\beta$ of the interlayer film 14, it is possible to reduce the difference in the length to be contracted with respect to the surface protective film 19. Therefore, the stress acting on the surface protective film 19 can be alleviated, and the film peeling 50 of the surface protective film 19 can be prevented.

Furthermore, the second wiring pattern 15 is electrically coupled to the first wiring pattern 14 via the conductive protective film 18. Therefore, it is not necessary to provide a via for electrically coupling the second wiring pattern 15 and the first wiring pattern 14. Furthermore, as a result, a step of forming the via can be eliminated.

Furthermore, by embedding the conductive protective film 18 in the interlayer film opening 17a on the first wiring pattern 14, the cross-sectional area of the conductive portion can be increased. Therefore, an impedance of the first wiring pattern 14 can be reduced, and signal attenuation and distortion can be prevented from occurring.

<2. Manufacturing Step of First Embodiment of Semiconductor Device According to Present Disclosure>

Next, a manufacturing step of the first embodiment of the semiconductor device 101 according to the present disclosure will be described. Figs. 4 to 15 are explanatory views according to cut end views at positions X-X in the manufacturing step of the first embodiment of the semiconductor device 101.

First, as illustrated in Fig. 4, the silicon substrate 10 is prepared. The circuit substrate 11 having the lower surface wiring pattern 31 on a lower surface thereof is bonded to the silicon substrate 10. Note that a method for bonding the circuit substrate 11 is not particularly limited.

Next, in the silicon substrate 10, a lower hole 30a of the TSV 30 that reaches the lower surface wiring pattern 31 is drilled in a vertical direction from the upper surface to the lower surface. Then, the upper surface of the silicon substrate 10 and the peripheral side surface in the lower hole 30a of the TSV 30 are covered with the insulating film 12.

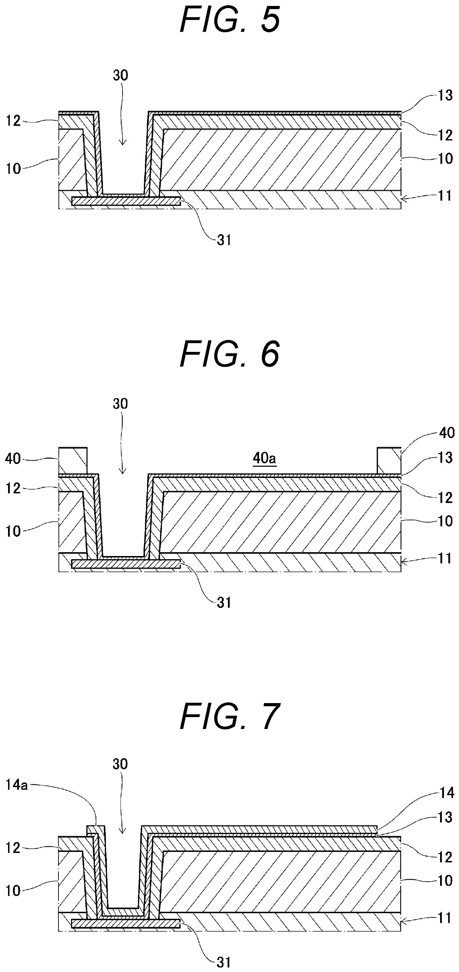

Next, as illustrated in Fig. 5, the seed metal 13 is formed on the upper surface of the insulating film 12. The seed metal 13 is formed using a physical vapor deposition (PVD) method such as a sputtering method, a plating method, a chemical vapor deposition (CVD) method using an organic metal material, and the like.

Next, as illustrated in Fig. 6, a pattern 40a of a photoresist 40 for forming the first wiring pattern 14 and the land pattern 14a is formed on the upper surface of the seed metal 13.

Next, as illustrated in Fig. 7, on the upper surface of the seed metal 13, the first wiring pattern 14 and the land pattern 14a are formed by electrolytic copper plating or the like following the shape of the pattern 40a of the photoresist 40 by photolithography.

After the first wiring pattern 14 and the land pattern 14a are formed, the seed metal 13 and the photoresist 40 other than these regions are removed.

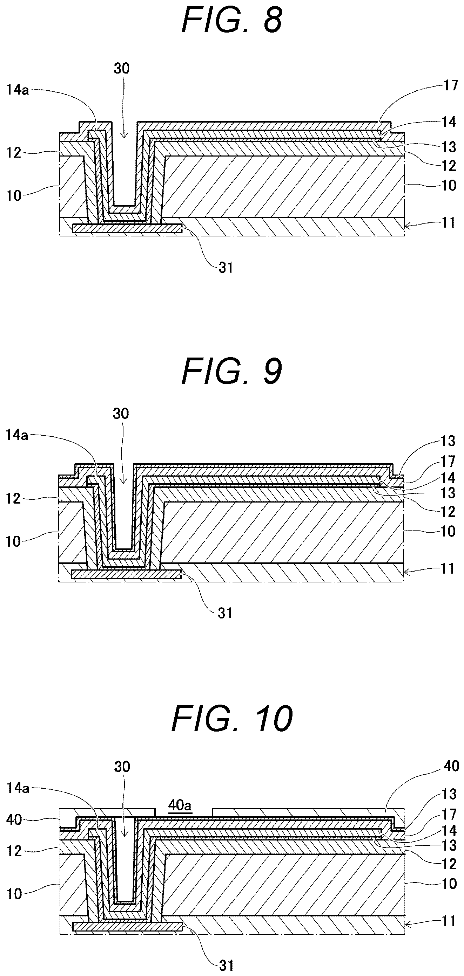

Next, as illustrated in Fig. 8, the entire upper surfaces of the first wiring pattern 14, the land pattern 14a, and the insulating film 12 are covered with the interlayer film 17.

Next, as illustrated in Fig. 9, the seed metal 13 is formed on the upper surface of the interlayer film 17. The forming step of the seed metal 13 is similar to that described in Fig. 5.

Next, as illustrated in Fig. 10, the pattern 40a of the photoresist 40 for forming the second wiring pattern 15 is formed on the upper surface of the seed metal 13. Therefore, the second wiring pattern 15 is formed by photolithography. This drawing illustrates an example of the pattern 40a of the photoresist 40 for forming the second wiring pattern 15 having the shape as illustrated in Fig. 1A.

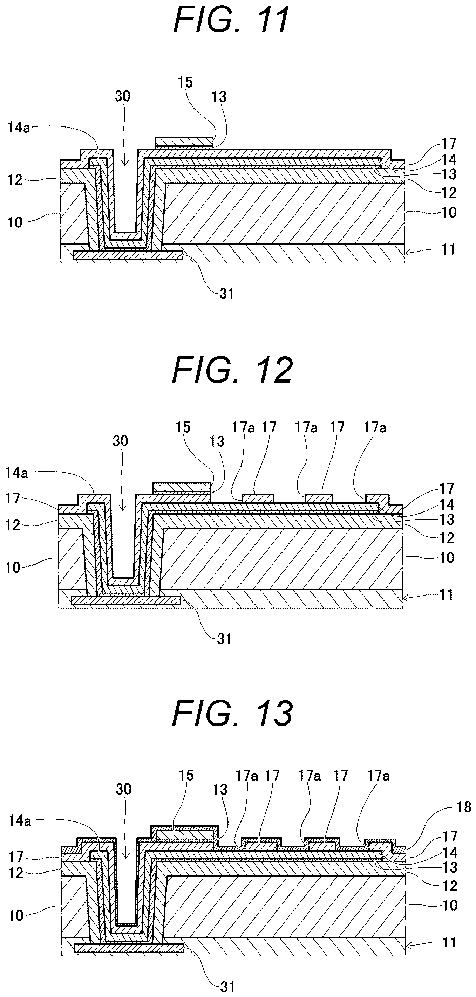

Next, as illustrated in Fig. 11, the second wiring pattern 15 is formed on the upper surface of the seed metal 13 by electrolytic copper plating or the like following the shape of the pattern 40a of the photoresist 40. After the second wiring pattern 15 is formed, the seed metal 13 and the photoresist 40 other than the region of the second wiring pattern 15 on the interlayer film 17 are removed.

Next, as illustrated in Fig. 12, predetermined regions of the interlayer film 17 covering the upper surface of the first wiring pattern 14 are removed by, for example, photolithography and the like to form the interlayer film openings 17a as illustrated in Figs. 1A to 1C.

Next, as illustrated in Fig. 13, the conductive protective film 18 is formed on the entire upper surfaces of the interlayer film 17, the interlayer film openings 17a, and the second wiring pattern 15.

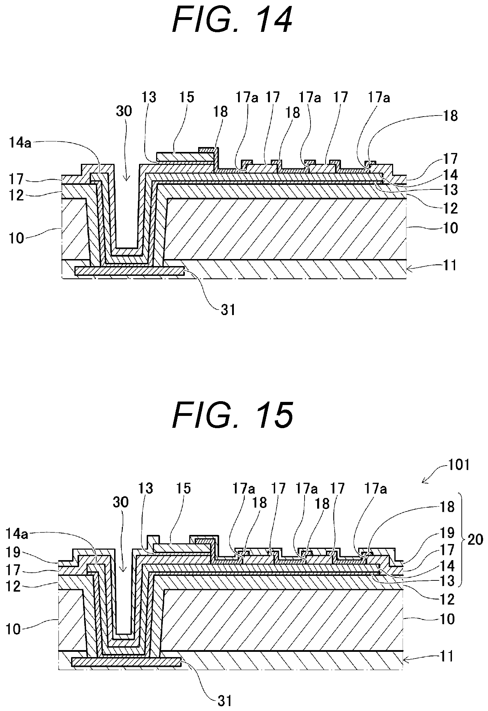

Next, as illustrated in Fig. 14, the conductive protective film 18 other than the interlayer film openings 17a and the predetermined region of the peripheral edge thereof is removed by photolithography and the like to leave the conductive protective film 18 as illustrated in Figs. 1A to 1C.

Furthermore, the conductive protective film 18 in contact with the second wiring pattern 15 is formed so as to cover the side end of the second wiring pattern 15. Therefore, the second wiring pattern 15 and the first wiring pattern 14 are electrically coupled via the conductive protective film 18.

Next, as illustrated in Fig. 15, the surface protective film 19 is formed on the entire upper surface of the interlayer film 17 and the entire upper surface of the conductive protective film 18. However, the surface protective film 19 on the upper surface of the conductive protective film 18 on the second wiring pattern 15 is removed by photolithography and the like.

The semiconductor device 101 as illustrated in Figs. 1A to 1C can be manufactured by having the manufacturing step as described above. Hereinafter, the semiconductor device 101 of the first embodiment according to the present disclosure can be manufactured through singulation, assembly, molding, inspection steps, and the like.

<3. Second Embodiment of Semiconductor Device According to Present Disclosure>

Next, a second embodiment of the semiconductor device 101 according to the present disclosure will be described.

In the second embodiment, as illustrated in an X end view of Fig. 16B, the seed metal 13 is further formed on the upper surface of the interlayer film 17 formed on the upper surface of the second wiring pattern 15, and a third wiring pattern 16 is formed on the upper surface thereof. That is, the second embodiment is a semiconductor device 101 having three or more layers of wiring patterns, and Fig. 16B is a view illustrating an example having three layers of wiring patterns.

As illustrated in the plan view of Fig. 16A, the third wiring pattern 16 in the second embodiment is formed in a region of the upper surface of the second wiring pattern 15 in such a manner as to overlap the second wiring pattern 15.

Then, the third wiring pattern 16 extends from the region to a region between the first wiring patterns 14 and 14, and extends from the extended region to the region between the first wiring patterns 14 and 14 in the right direction in the drawing and in parallel to the first wiring patterns 14 and 14.

Note that the upper surface of the third wiring pattern 16 may be covered with the interlayer film 17, the interlayer film openings 17a may be opened at predetermined intervals, and the conductive protective film 18 may be embedded therein, similarly to the first wiring pattern 14.

Furthermore, since a Y end view according to the second embodiment is similar to Fig. 1C except that the second wiring pattern 15 and the third wiring pattern 16 are formed on the upper surface of the first wiring pattern 14 at the Y end surface portion, the description thereof will be omitted.

However, the shape of third wiring pattern 16 is not necessarily the shape illustrated in Fig. 16A, and may be formed into a shape suitable for the application.

Furthermore, in Figs. 16A and 16B, an example has been described in which three layers of wiring patterns of the first wiring pattern 14, the second wiring pattern 15, and the third wiring pattern 16 are provided, but the present disclosure is not limited to these three layers, and three or more layers may be provided.

Since the configuration of the second embodiment of the semiconductor device 101 other than the above is similar to that of the first embodiment, the description thereof will be omitted.

Furthermore, in the manufacturing step of the second embodiment of the semiconductor device 101, it is only required to add and the like a step of covering the upper surface of the second wiring pattern 15 with the interlayer film 17, further forming the seed metal 13 on the upper surface thereof, and forming the third wiring pattern 16 on the upper surface thereof. Since other steps are similar to the steps described above with reference to Figs. 4 to 15, the description thereof will be omitted.

Since the semiconductor device 101 of the second embodiment is configured as described above, the third wiring pattern 16 can be electrically coupled to the second wiring pattern 15 or the first wiring pattern 14 via the conductive protective film 18 covering the side end thereof. Therefore, it is not necessary to provide a via for electrical coupling with the second wiring pattern 15 and the first wiring pattern 14. Therefore, a step of forming the via can be eliminated. This is similar to a case where the number of wiring patterns is three or more.

Since the effects of the second embodiment of the semiconductor device 101 other than the above are similar to those of the first embodiment, the description thereof will be omitted.

<4. Third Embodiment of Semiconductor Device According to Present Disclosure>

Next, a third embodiment of the semiconductor device 101 according to the present disclosure will be described.

In the third embodiment, as illustrated in Figs. 17A and 17B, in the conductive protective film 18 embedded in the interlayer film opening 17a of the interlayer film 17, an upper surface of a part of the interlayer film opening 17a is not covered with the surface protective film 19, and a conductive protective film opening 18a in an open state is formed. Note that Fig. 17A is different from Figs. 1A, 16A, 18A, 19A, and 20A in that the upper surfaces of the interlayer film 17 and the conductive protective film 18 are covered with the surface protective film 19. However, in Fig. 17A, the description of the undulating shape formed on the upper surface of the surface protective film 19 is omitted in order to avoid complication.

Since a Y end view of the third embodiment is similar to that of Fig. 1C except that an upper surface of a part of the interlayer film opening 17a is not covered with the surface protective film 19 to form the conductive protective film opening 18a, the description thereof will be omitted. Note that Fig. 17B illustrates an example in which two layers of wiring patterns of the first wiring pattern 14 and the second wiring pattern 15 are provided, but as illustrated in Figs. 16A and 16B, three or more layers of wiring patterns such as the third wiring pattern 16 may be provided.

Since the configuration of the third embodiment of the semiconductor device 101 other than the above is similar to that of the first embodiment, the description thereof will be omitted.

Furthermore, in the manufacturing step of the third embodiment of the semiconductor device 101, it is only required to add and the like a step of opening the conductive protective film opening 18a to the conductive protective film 18 embedded in the interlayer film opening 17a. Since other steps are similar to the steps described above with reference to Figs. 4 to 15, the description thereof will be omitted.

As described above, in the semiconductor device 101 of the third embodiment, the conductive protective film opening 18a is opened in the conductive protective film 18 embedded in the interlayer film opening 17a. Therefore, an external coupling terminal (not illustrated) or a bump (not illustrated) can be formed on the conductive protective film opening 18a. Therefore, the first wiring pattern 14 can be electrically coupled to an external semiconductor chip, substrate, and the like.

Since the effects of the third embodiment of the semiconductor device 101 other than the above are similar to those of the first embodiment, the description thereof will be omitted.

<5. Fourth Embodiment of Semiconductor Device According to Present Disclosure>

Next, a fourth embodiment of the semiconductor device 101 according to the present disclosure will be described.

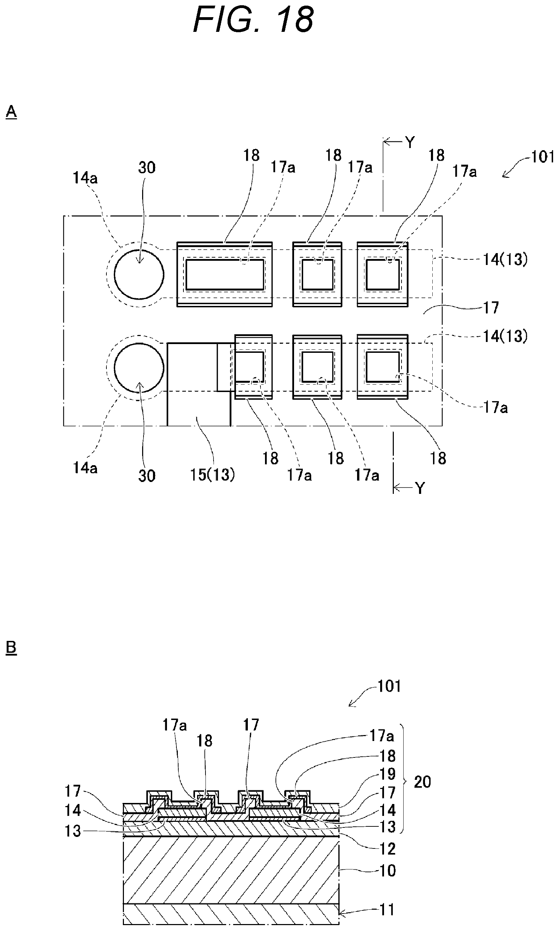

In the fourth embodiment, as illustrated in Figs. 18A and 18B, the conductive protective film 18 is embedded in the interlayer film opening 17a formed in the interlayer film 17, and the width of the conductive protective film 18 in the Y direction is formed to be wider than the width of the interlayer film opening 17a. That is, the conductive protective film 18 covering the interlayer film opening 17a is formed to be wider than the width of the first wiring pattern 14, and the peripheral edge of the interlayer film opening 17a is covered with the conductive protective film 18 via the interlayer film 17.

Since an X end view of the fourth embodiment is similar to that illustrated in Fig. 1B, the description thereof will be omitted. Note that Fig. 1B illustrates an example in which two layers of wiring patterns of the first wiring pattern 14 and the second wiring pattern 15 are provided, but as illustrated in Figs. 16A and 16B, three or more layers of wiring patterns such as the third wiring pattern 16 may be provided.

Since the configuration of the fourth embodiment of the semiconductor device 101 other than the above is similar to that of the first embodiment, the description thereof will be omitted.

Furthermore, in the manufacturing step of the fourth embodiment of the semiconductor device 101, it is only required to change the step illustrated in Fig. 14 such that the width of the conductive protective film 18 in the Y direction is wider than the width of the interlayer film opening 17a in the Y direction. Since other steps are similar to the steps described above with reference to Figs. 4 to 15, the description thereof will be omitted.

As described above, the semiconductor device 101 according to the fourth embodiment is configured such that the width of the conductive protective film 18 in the Y direction is wider than the width of the interlayer film opening 17a in the Y direction. Therefore, a stress caused by the difference in the linear expansion coefficient acting in the X direction can be further alleviated. Therefore, it is possible to prevent the film peeling 50 of the interlayer film 17.

Since the effects of the fourth embodiment of the semiconductor device 101 other than the above are similar to those of the first embodiment, the description thereof will be omitted.

<6. Fifth Embodiment of Semiconductor Device According to Present Disclosure>

Next, a fifth embodiment of the semiconductor device 101 according to the present disclosure will be described.

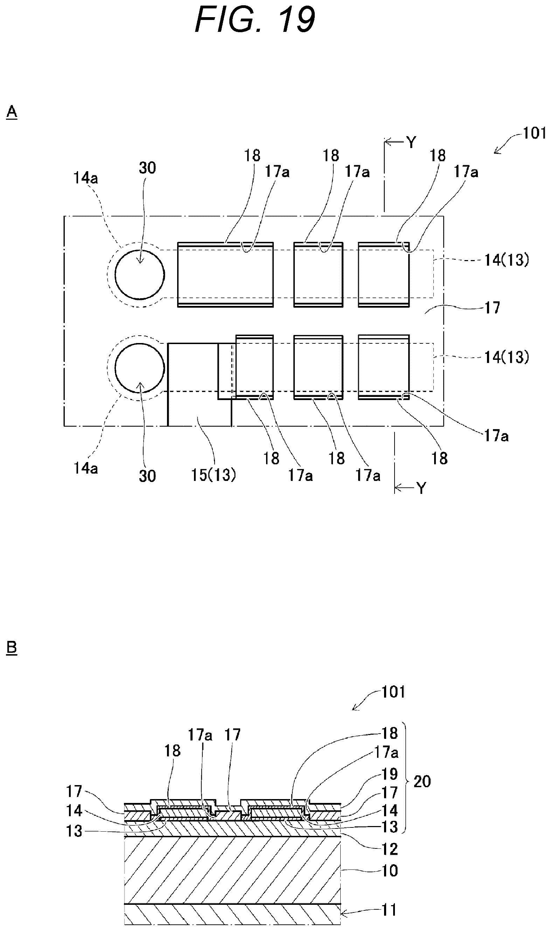

In the fifth embodiment, as illustrated in Figs. 19A and 19B, the interlayer film opening 17a formed in the interlayer film 17 has a width in the Y direction so as to be opened wider than the width of the first wiring pattern 14, and the conductive protective film 18 is embedded so as to be in contact with the upper surface and both side surfaces of the first wiring pattern 14. That is, the conductive protective film 18 covering the interlayer film opening 17a is opened wider than the width of the first wiring pattern 14, and the upper surface and the peripheral side surface of the first wiring pattern 14 are covered with the conductive protective film 18.

Since an X end view of the fifth embodiment is similar to that illustrated in Fig. 1B, the description thereof will be omitted. Note that Fig. 1B illustrates an example in which two layers of wiring patterns of the first wiring pattern 14 and the second wiring pattern 15 are provided, but as illustrated in Figs. 16A and 16B, three or more layers of wiring patterns such as the third wiring pattern 16 may be provided.

Since the configuration of the fifth embodiment of the semiconductor device 101 other than the above is similar to that of the first embodiment, the description thereof will be omitted.

Furthermore, in the manufacturing step of the fifth embodiment of the semiconductor device 101, it is only required to change the steps illustrated in Figs. 12 to 14 such that the interlayer film opening 17a has a width in the Y direction so as to be opened wider than the width of the first wiring pattern 14 and the conductive protective film 18 is embedded in contact with the upper surface and the both side surfaces of the first wiring pattern 14. Since other steps are similar to the steps described above with reference to Figs. 4 to 15, the description thereof will be omitted.

As described above, the semiconductor device 101 of the fifth embodiment is configured such that the width of the interlayer film opening 17a in the Y direction is wider than the width of the first wiring pattern 14, and the conductive protective film 18 is embedded so as to be in contact with the upper surface and the both side surfaces of the first wiring pattern 14. Therefore, a stress caused by the difference in the linear expansion coefficient acting in the X direction can be further alleviated. Therefore, it is possible to prevent the film peeling 50 of the interlayer film 17.

Since the effects of the fifth embodiment of the semiconductor device 101 other than the above are similar to those of the first embodiment, the description thereof will be omitted.

<7. Sixth Embodiment of Semiconductor Device According to Present Disclosure>

Next, a sixth embodiment of the semiconductor device 101 according to the present disclosure will be described.

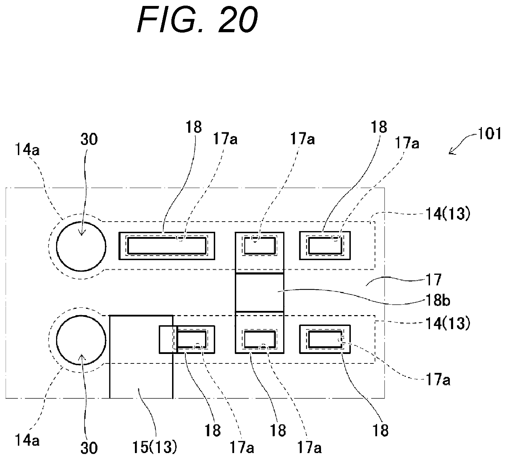

In the sixth embodiment, for example, the upper surfaces of the two first wiring patterns 14 and 14 on the same plane formed on the insulating film 12 are covered with the interlayer film 17, the interlayer film openings 17a and 17a formed in the interlayer film 17 are embedded with the conductive protective film 18, and the conductive protective films 18 and 18 of the interlayer film openings 17a and 17a are connected to each other by the connecting conductive protective film 18b as illustrated in the plan view of Fig. 20. The connecting conductive protective film 18b includes the same material as the conductive protective film 18. Therefore, the first wiring patterns 14 and 14 can be electrically coupled to each other via the conductive protective films 18 and 18 and the connecting conductive protective film 18b.

Even in a case where two or more wiring patterns are formed on the same plane of the interlayer film 17, the wiring patterns can be similarly connected by the connecting conductive protective film 18b.

Since an X end view of the sixth embodiment is similar to that illustrated in Fig. 1B, the description thereof will be omitted. Furthermore, since the Y end view is the similar to that of Fig. 1C, 18B, or 19B except that the conductive protective films 18 and 18 embedding the interlayer film openings 17a and 17a are connected to each other by the connecting conductive protective film 18b, the description thereof will be omitted. Note that Fig. 1B illustrates an example in which two layers of wiring patterns of the first wiring pattern 14 and the second wiring pattern 15 are provided, but as illustrated in Figs. 16A and 16B, three or more layers of wiring patterns such as the third wiring pattern 16 may be provided.

Furthermore, in Fig. 20, an example in which the conductive protective films 18 and 18 on the two parallel first wiring patterns 14 and 14 are connected to each other by the connecting conductive protective film 18b has been described, but the two first wiring patterns 14 and 14 may not be disposed in parallel. Furthermore, the number of the first wiring patterns 14 is not limited to two, and the plurality of first wiring patterns 14 may be sequentially connected by the connecting conductive protective film 18b.

Since the configuration of the sixth embodiment of the semiconductor device 101 other than the above is similar to that of the first embodiment, the description thereof will be omitted.

Furthermore, in the manufacturing step of the sixth embodiment of the semiconductor device 101, when the interlayer film openings 17a and 17a formed in the interlayer film 17 covering the upper surfaces of the first wiring patterns 14 and 14 are embedded with the conductive protective film 18 respectively, it is only required to change the shape of the conductive protective film 18 in the step illustrated in Fig. 14 such that the conductive protective films 18 and 18 are connected to each other by the connecting conductive protective film 18b. Since other steps are similar to the steps described above with reference to Figs. 4 to 15, the description thereof will be omitted.

As described above, in the semiconductor device 101 of the sixth embodiment, the interlayer film openings 17a and 17a formed in the interlayer film 17 covering the upper surfaces of the first wiring patterns 14 and 14 are embedded with the conductive protective film 18 respectively, and the conductive protective films 18 and 18 are connected to each other by the connecting conductive protective film 18b. Therefore, the first wiring patterns 14 and 14 can be connected to each other via the conductive protective film 18 and the connecting conductive protective film 18b. Furthermore, the connecting conductive protective film 18b can be formed in the forming step of the conductive protective film 18.

Therefore, although it is necessary to form another layer of wiring pattern in some cases in order to connect the first wiring patterns 14 and 14, the connecting conductive protective film 18b can be formed at the same time in the forming step of the conductive protective film 18, so that it is not necessary to provide the forming step of a wiring pattern using copper (Cu).

Since the effects of the sixth embodiment of the semiconductor device 101 other than the above are similar to those of the first embodiment, the description thereof will be omitted.

<8. Electronic Apparatus Having Semiconductor Device According to Present Disclosure>

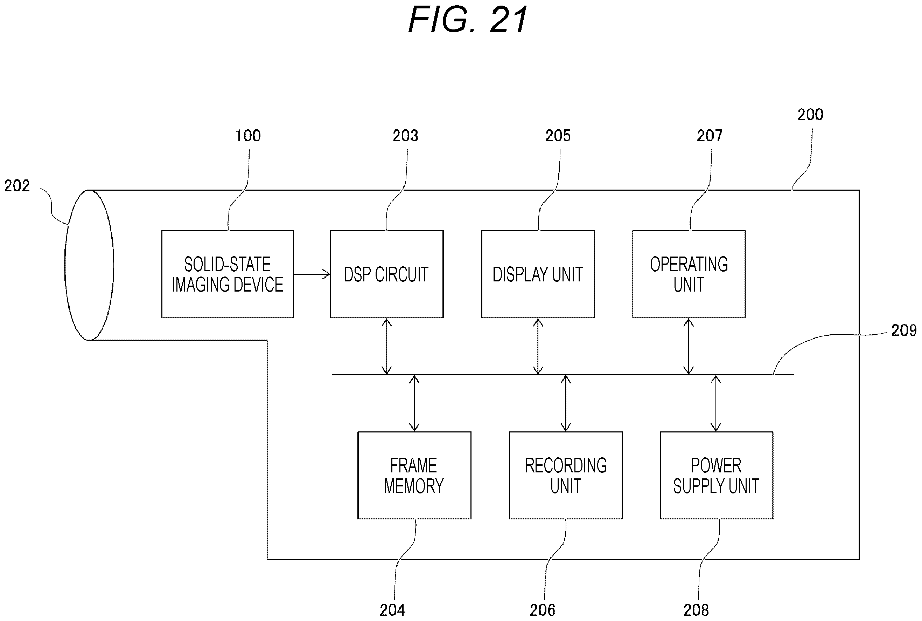

A configuration example of an electronic apparatus having a solid-state imaging device 100 as an example of the semiconductor devices 101 according to the first embodiment to sixth embodiment will be described with reference to Fig. 21.

The semiconductor device 101 according to the present disclosure can be applied to an imaging device such as a digital still camera, a video camera, and the like, a mobile terminal device having an imaging function, or an imaging apparatus such as a copier using the solid-state imaging device 100 as an image reading unit. Furthermore, application thereof is not limited to the imaging apparatus, and can be widely applied to a general electronic apparatus such as an industrial apparatus including an electric home appliance, a communication apparatus, and an in-vehicle apparatus.

Note that the solid-state imaging device 100 may be a CMOS sensor or a CCD sensor. Furthermore, the solid-state imaging device 100 may be formed as one chip, or may be in the form of a module having an imaging function in which an imaging unit and a signal processing unit or an optical system are packaged together.

As illustrated in Fig. 21, an imaging device 200 as an electronic apparatus includes an optical unit 202, the solid-state imaging device 100, a digital signal processor (DSP) circuit 203, which is a camera signal processing circuit, a frame memory 204, a display unit 205, a recording unit 206, an operating unit 207, and a power supply unit 208. The DSP circuit 203, the frame memory 204, the display unit 205, the recording unit 206, the operating unit 207, and the power supply unit 208 are coupled to one another via a bus line 209.

The optical unit 202 includes a plurality of lenses, and captures incident light (image light) from a subject to form an image on a pixel region (not illustrated) of the solid-state imaging device 100. The solid-state imaging device 100 converts a light amount of the incident light imaged on the pixel region thereof by the optical unit 202 into an electric signal in a pixel unit to output as a pixel signal.

The display unit 205 including a panel display device such as a liquid crystal panel, an organic electro luminescence (EL) panel, and the like, for example, displays a moving image or a still image captured by the solid-state imaging device 100. The recording unit 206 records the moving image or the still image captured by the solid-state imaging device 100 on a recording medium such as a hard disk or a semiconductor memory.

The operating unit 207 issues operation commands for various functions of the imaging device 200 under operation by a user. The power supply unit 208 appropriately supplies various power sources serving as operation power sources of the DSP circuit 203, the frame memory 204, the display unit 205, the recording unit 206, and the operating unit 207 to these supply targets.

Furthermore, the semiconductor device 101 according to the present disclosure can be widely applied not only to the solid-state imaging device 100 but also to various semiconductor devices 101 configuring circuits such as the DSP circuit 203, the frame memory 204, the recording unit 206, the display unit 205, the operating unit 207, and the like.

As described above, according to the present disclosure, by using the solid-state imaging device 100 which is an example of the semiconductor device 101 according to the present disclosure, it is possible to obtain the highly reliable imaging device 200 that does not cause the film peeling 50.

Finally, the description of each of the above-described embodiments is an example of the present disclosure, and the present disclosure is not limited to the above-described embodiments. For this reason, it is needless to say that various modifications other than each of the above-described embodiments can be made according to the design and the like without departing from the technical idea according to the present disclosure. Furthermore, the effects described in the present specification are merely examples and are not limited, and other effects may be further provided.

Note that the present technology can also have the following configurations.

(1) A semiconductor device including:

a silicon substrate;
an insulating film laminated on the silicon substrate;
at least one or more wiring patterns formed on the insulating film;
an interlayer film laminated between the one or more wiring patterns; and
a conductive protective film embedded in an interlayer film opening formed in the interlayer film.

(2) The semiconductor device according to (1), in which an entire surface of the conductive protective film is covered with a surface protective film.

(3) The semiconductor device according to (2), in which the surface protective film that covers the conductive protective film has an opening.

(4) The semiconductor device according to any one of (1) to (3), in which the conductive protective film is formed to be wider than a width of the wiring pattern, and a peripheral edge of the interlayer film opening is covered with the conductive protective film via the interlayer film.

(5) The semiconductor device according to any one of (1) to (3), in which the interlayer film opening is opened wider than a width of the wiring pattern, and an upper surface and a peripheral side surface of the wiring pattern are covered with the conductive protective film.

(6) The semiconductor device according to any one of (1) to (5), in which at least two or more of the wiring patterns formed on a same plane on the insulating film or the interlayer film are electrically coupled to each other via a connecting conductive protective film that connects the conductive protective films embedded in the interlayer film openings of the interlayer film on the respective wiring patterns.

(7) The semiconductor device according to any one of (1) to (6), in which the surface protective film includes an inorganic film including silicon dioxide ($SiO_2$) and silicon nitride ($Si_3N_4$), an organic film such as a polyimide-based resin, or a laminated structure of these films.

(8) The semiconductor device according to any one of (1) to (7), in which a linear expansion coefficient of the conductive protective film has a relationship that is larger than a linear expansion coefficient of the insulating film and smaller than a linear expansion coefficient of a material of the wiring pattern.

(9) The semiconductor device according to any one of (1) to (8), in which the conductive protective film includes titanium (Ti), nickel (Ni), or an alloy containing these elements.

(10) The semiconductor device according to any one of (1) to (9), in which the conductive protective film has a laminated structure including at least one or more layers of the titanium (Ti), nickel (Ni), or alloy including these elements.

(11) A method for manufacturing a semiconductor device, the method including:

a step of forming a silicon substrate;
a step of forming an insulating film on an upper surface of the silicon substrate;
a step of forming at least one or more wiring patterns on an upper surface of the insulating film;
a step of forming an interlayer film on an upper surface of the wiring pattern;
a step of forming an interlayer film opening having a predetermined shape in the interlayer film; and
a step of forming a conductive protective film on an upper surface of the interlayer film and embedding the conductive protective film in the interlayer film opening.

(12) The method for manufacturing a semiconductor device according to (11), in which the step of forming the silicon substrate has a step of bonding a circuit substrate having a wiring pattern on a lower surface of the silicon substrate, and providing a through-Si electrode coupled to the wiring pattern from the upper surface of the silicon substrate.

(13) An electronic apparatus having a semiconductor device including:

a silicon substrate,
an insulating film laminated on the silicon substrate,
at least one or more wiring patterns formed on the insulating film,
an interlayer film laminated between the one or more wiring patterns, and
a conductive protective film embedded in an interlayer film opening formed in the interlayer film.

REFERENCE SIGNS LIST

| | |
|---|---|
| 10 | Silicon substrate |
| 11 | Circuit substrate |
| 12 | Insulating film |
| 13 | Seed metal |
| 14 | First wiring pattern |
| 14a | Land pattern |
| 15 | Second wiring pattern |
| 16 | Third wiring pattern |
| 17 | Interlayer film |
| 17a | Interlayer film opening |
| 18 | Conductive protective film |
| 18a | Conductive protective film opening |
| 18b | Connecting conductive protective film |
| 19 | Surface protective film |
| 20 | Redistribution layer |
| 30 | TSV |
| 30a | Lower hole |
| 31 | Lower surface wiring pattern |
| 40 | Photoresist |
| 40a | Pattern |
| 50 | Film peeling |
| 100 | Solid-state imaging device |
| 101 | Semiconductor device |
| 200 | Imaging device |
| L, L1, L2, L3, L4, La, and Lb | Length |
| $\alpha$, $\beta$, $\gamma$ | Linear expansion coefficient |
| d | Ratio |

**Claims**

1. A semiconductor device comprising:

a silicon substrate;

an insulating film laminated on the silicon substrate;
at least one or more wiring patterns formed on the insulating film;
an interlayer film laminated between the one or more wiring patterns; and
a conductive protective film embedded in an interlayer film opening formed in the interlayer film.

2. The semiconductor device according to claim 1, wherein an entire surface of the conductive protective film is covered with a surface protective film.

3. The semiconductor device according to claim 2, wherein the surface protective film that covers the conductive protective film has an opening.

4. The semiconductor device according to claim 1, wherein the conductive protective film is formed to be wider than a width of the wiring pattern, and a peripheral edge of the interlayer film opening is covered with the conductive protective film via the interlayer film.

5. The semiconductor device according to claim 1, wherein the interlayer film opening is opened wider than a width of the wiring pattern, and an upper surface and a peripheral side surface of the wiring pattern are covered with the conductive protective film.

6. The semiconductor device according to claim 1, wherein at least two or more of the wiring patterns formed on a same plane on the insulating film or the interlayer film are electrically coupled to each other via a connecting conductive protective film that connects the conductive protective films embedded in the interlayer film openings of the interlayer film on the respective wiring patterns.

7. The semiconductor device according to claim 1, wherein the surface protective film includes an inorganic film including silicon dioxide ($SiO_2$) and silicon nitride ($Si_3N_4$), an organic film such as a polyimide-based resin, or a laminated structure of these films.

8. The semiconductor device according to claim 1, wherein a linear expansion coefficient of the conductive protective film has a relationship that is larger than a linear expansion coefficient of the insulating film and smaller than a linear expansion coefficient of a material of the wiring pattern.

9. The semiconductor device according to claim 1, wherein the conductive protective film includes titanium (Ti), nickel (Ni), or an alloy containing these elements.

10. The semiconductor device according to claim 1, wherein the conductive protective film has a laminated structure including at least one or more layers of the titanium (Ti), nickel (Ni), or alloy including these elements.

11. A method for manufacturing a semiconductor device, the method comprising:

a step of forming a silicon substrate;
a step of forming an insulating film on an upper surface of the silicon substrate;
a step of forming at least one or more wiring patterns on an upper surface of the insulating film;
a step of forming an interlayer film on an upper surface of the wiring pattern;
a step of forming an interlayer film opening having a predetermined shape in the interlayer film; and
a step of forming a conductive protective film on an upper surface of the interlayer film and embedding the conductive protective film in the interlayer film opening.

12. The method for manufacturing a semiconductor device according to claim 11, wherein the step of forming the silicon substrate has a step of bonding a circuit substrate having a wiring pattern on a lower surface of the silicon substrate, and providing a through-Si electrode coupled to the wiring pattern from the upper surface of the silicon substrate.

13. An electronic apparatus having a semiconductor device including:

a silicon substrate,
an insulating film laminated on the silicon substrate,
at least one or more wiring patterns formed on the insulating film,
an interlayer film laminated between the one or more wiring patterns, and

a conductive protective film embedded in an interlayer film opening formed in the interlayer film.

# FIG. 1

EP 4 510 172 A1

# FIG. 2

# FIG. 3

# FIG. 4

## FIG. 5

## FIG. 6

## FIG. 7

## FIG. 8

## FIG. 9

## FIG. 10

## FIG. 11

## FIG. 12

## FIG. 13

# FIG. 14

# FIG. 15

# FIG. 16

A

B

# FIG. 17

A

14a  30  18a  18  17a  18  17a  18a  18  17a  101

14(13)

19(17)

14(13)

X                                    X

17a

14a  30  15(13)  18a  18  17a  18  17a  18
18a

B

101

30  18a  15 13 17a  17  17a  17  17a  18a  18

20  14a  19  17  12  10  31
19  17  14  13  12  10  11  20

# FIG. 18

A

B

# FIG. 19

A

B

## FIG. 20

## FIG. 21

## INTERNATIONAL SEARCH REPORT

International application No.

**PCT/JP2023/013964**

### A. CLASSIFICATION OF SUBJECT MATTER

*H01L 21/3205*(2006.01)i; *H01L 21/768*(2006.01)i; *H01L 23/522*(2006.01)i; *H01L 23/532*(2006.01)i
FI: H01L21/88 S; H01L21/90 J; H01L21/88 J; H01L21/90 A; H01L21/88 R

According to International Patent Classification (IPC) or to both national classification and IPC

### B. FIELDS SEARCHED

Minimum documentation searched (classification system followed by classification symbols)

H01L21/3205; H01L21/768; H01L23/522; H01L23/532

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2011-171567 A (ELPIDA MEMORY INC) 01 September 2011 (2011-09-01) paragraphs [0067]-[0073], fig. 23, 24 | 1-3, 7-13 |
| A | | 4-6 |
| Y | WO 2018/142976 A1 (MURATA MANUFACTURING CO., LTD.) 09 August 2018 (2018-08-09) fig. 5 | 1-3, 7-13 |
| Y | JP 2019-114750 A (RENESAS ELECTRONICS CORP) 11 July 2019 (2019-07-11) fig. 2 | 2, 3 |
| Y | JP 2002-313791 A (MATSUSHITA ELECTRIC IND CO LTD) 25 October 2002 (2002-10-25) paragraphs [0021]-[0025] | 9, 10 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **05 June 2023** | **13 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/013964**

| Patent document cited in search report | | | Publication date (day/month/year) | Patent family member(s) | Publication date (day/month/year) |
|---|---|---|---|---|---|
| JP | 2011-171567 | A | 01 September 2011 | US 2011/0207322 A1 paragraphs [0122]-[0130], fig. 23, 24 | |
| WO | 2018/142976 | A1 | 09 August 2018 | (Family: none) | |
| JP | 2019-114750 | A | 11 July 2019 | US 2019/0198468 A1 fig. 2 | |
| JP | 2002-313791 | A | 25 October 2002 | (Family: none) | |

Form PCT/ISA/210 (patent family annex) (January 2015)

## EP 4 510 172 A1

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006 A

- JP 318989 A